Europäisches Patentamt

European Patent Office

Office européen des brevets

(11) Numéro de publication : **0 316 223 B1**

# (12) FASCICULE DE BREVET EUROPEEN

(45) Date de publication du fascicule du brevet :
15.07.92 Bulletin 92/29

(51) Int. Cl.⁵ : **H03M 1/34**

(21) Numéro de dépôt : **88402782.2**

(22) Date de dépôt : **04.11.88**

---

(54) **Convertisseur analogique-numérique à cascade.**

---

(30) Priorité : **10.11.87 FR 8715535**

(43) Date de publication de la demande :
**17.05.89 Bulletin 89/20**

(45) Mention de la délivrance du brevet :
**15.07.92 Bulletin 92/29**

(84) Etats contractants désignés :
**DE GB IT NL**

(56) Documents cités :
**EP-A- 0 112 180**
**US-A- 3 858 200**
**PATENT ABSTRACTS OF JAPAN, vol. 7, no. 65**
**(E-165)[210], 18 mars 1983, page 156 E 165; &**
**JP-A-57 212 823**

(73) Titulaire : **THOMSON COMPOSANTS**
**MICROONDES**
**51, Esplanade du Général de Gaulle**
**F-92800 Puteaux (FR)**

(72) Inventeur : **Tung, Pham Ngu**
**THOMSON-CSF SCPI 19, avenue de Messine**
**F-75008 Paris (FR)**

(74) Mandataire : **Taboureau, James et al**
**THOMSON-CSF SCPI**
**F-92045 Paris La Défense Cédex 67 (FR)**

---

## Description

La présente invention concerne un convertisseur analogique-numérique. Destiné à fonctionner dans les hyperfréquences, à de très grandes vitesses de conversion, il transforme un signal analogique en un signal numérique de précision, avec un grand nombre de bits, à travers trois étages seulement, et ne requiert qu'un petit nombre de transistors, dont la plupart travaillent en parallèle et n'interviennent pas dans le temps de conversion. Le signal d'entrée, adressé à autant de circuits comparateurs qu'il y a de bits dans le signal de sortie, n'est séparé de celui-ci que par deux jonctions grille-drain, de deux transistors. Les comparateurs travaillent en cascade.

Un convertisseur à cascade classique est connu de la demande de brevet japonaise JP-A-57 212 823. Il transforme d'abord la tension d'entrée analogique $V_E$ en un courant analogique $I_E$, puis, pour chaque niveau de bit de sortie, compare ce courant $I_E$ à un courant étalonné $nI_o$. Le courant résultant, positif ou négatif est adressé à un circuit logique, dont une première sortie commande en partie les comparateurs de tous les niveaux de bits de poids inférieurs, et dont une deuxième sortie fournit un bit du signal numérique.

La commande partielle des comparateurs s'explique ainsi : chaque comparateur est formé par une série de sources de courants élémentaires, montées en parallèle, et qui débitent des courants en progression géométrique $2^n$ : 1,2,4,8..., avec un transistor comme interrupteur. Dans une telle série de sources de courants, certaines peuvent être bloquées, selon l'état de la première sortie du circuit logique qui les commande, tandis que d'autres débitent un courant fixe.

De plus, chaque comparateur étant formé par plusieurs sources de courants élémentaires, la première sortie d'un circuit logique qui fournit un bit de niveau N commande toutes les sources de courants élémentaires, qui débitent un courant $2^N I_o$, de tous les niveaux de bits inférieurs : il y a donc cascade entre les niveaux de conversion.

L'invention concerne un convertisseur analogique-numérique, transformant un signal analogique d'entrée en un signal numérique de sortie formé par une pluralité de bits.

Selon le préambule de la revendication 1, caractérisé en ce que, pour chaque niveau de bit, l'étage de sortie est un circuit logique qui comprend :
  – un inverseur constitué par un premier transistor inverseur normalement bloqué, et un transistor source de courant, normalement passant,
  – un suiveur constitué par un second transistor inverseur en série avec un transistor monté en source suiveuse, tous deux normalement bloqués, la grille du transistor monté sen source suiveuse étant réunie au point commun aux deux transistors de l'inverseur,
  – le signal issu du comparateur étant appliqué sur les grilles des deux transistors inverseurs
  – le point commun aux deux transistors de l'inverseur constituant une première sortie de commande des sources de courants élémentaires du comparateur, et le point commun aux deux transistors du suiveur constituant une seconde sortie du bit.

L'invention sera mieux comprise au moyen de la description détaillée qui suit, en conjonction avec les figures jointes en annexe, qui représentent :
  – figure 1 : schéma en bloc-diagramme du convertisseur analogique-numérique selon l'art antérieur,
  – figure 2 : schéma électrique du convertisseur selon l'invention,
  – figure 3 : schéma électrique d'une variante du convertisseur précédent, permettant une plus grande précision.

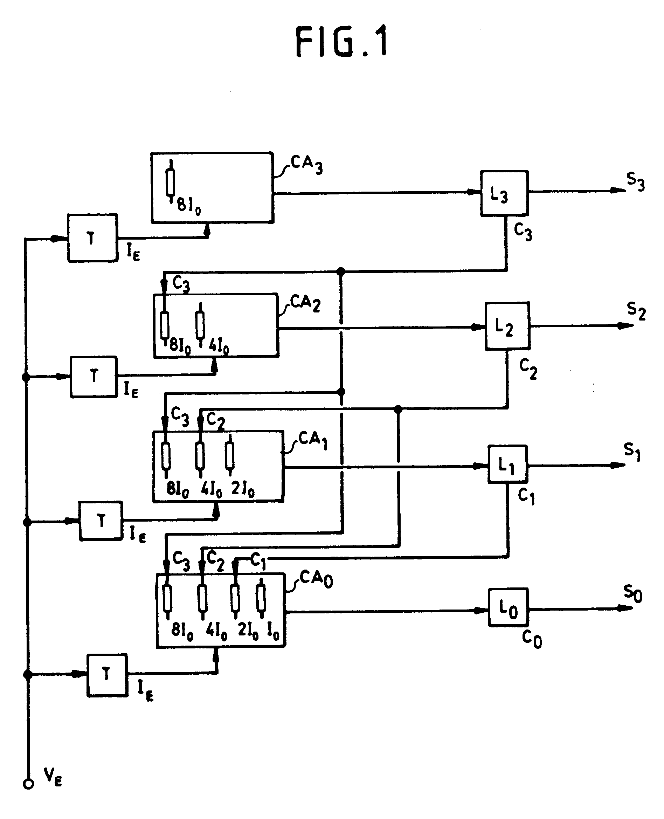

La figure 1 représente un schéma en bloc-diagramme d'un convertisseur analogique-numérique (CAN) à cascade. Ce schéma est très simplifié pour rendre l'explication plus claire.

Un signal analogique $V_E$, appliqué sur la borne d'entrée du CAN, est adressé en parallèle à autant de transistors T que de bits dans le signal numérique de sortie. A titre d'exemple non limitatif, le circuit de la figure 1 transforme le signal analogique $V_E$ en un signal numérique à 4 bits $S_0 S_1 S_2 S_3$ : il y a 4 niveaux de bits, et 4 transducteurs d'entrée I. Chaque transducteur T, qui est un transistor, transforme la tension $V_E$ en un courant $I_E$ qui lui est proportionnel.

Pour chaque niveau de bit, le courant $I_E$ est comparé avec le courant étalonné fourni par un comparateur analogique CA. Un comparateur analogique comprend deux sources de courants : la première n'est autre que le transducteur T qui fournit un courant $I_E$, et la deuxième est une source composite qui fournit un courant $nI_o$ multiple d'un courant élémentaire $I_o$.

Une source composite comprend, connectée en parallèle :
  – une source élémentaire, non commandée par un transistor, qui débite un courant constant $2^N I_o$, N étant l'ordre, ou le poids du bit dans le niveau considéré,
  – autant de sources élémentaires, commandées chacune par un transistor, qu'il y a de niveaux de bits de poids plus élevé que le niveau considéré, et en outre ces sources élémentaires débitent des courants en progression géométrique.

Ainsi, à titre d'exemple basé sur la figure 1 - 4 bits -:

– le niveau 0, premier bit, comprend une source non commandée $I_o = 2^0 I_o$ et trois sources commandées $2I_o$, $2^2 I_o$, $2^3 I_o$, parce qu'il y a trois niveaux de bits au-dessus du niveau 0.

– le niveau 1, second bit, comprend une source non commandée $2^1 I_o$ et deux sources commandées $2^2 i_o$, $2^3 I_o$.

– le niveau 2, troisième bit, comprend une source non commandée $2^2 I_o$ et une source commandée $2^3 I_o$.

– le niveau 3, quatrième bit, ne comprend qu'une source non commandée $2^3 I_o$. C'est le bit de poids le plus lourd.

Le courant résultant du comparateur analogique est adressé à un circuit logique L doté de deux sorties. La première sortie fournit un signal de commande C qui, selon l'état haut ou bas de sortie du comparateur, bloque ou débloque les transistors de commande des sources élémentaires correspondantes de tous les comparateurs des niveaux inférieurs. La seconde sortie fournit un bit du signal numérique, objet de la conversion.

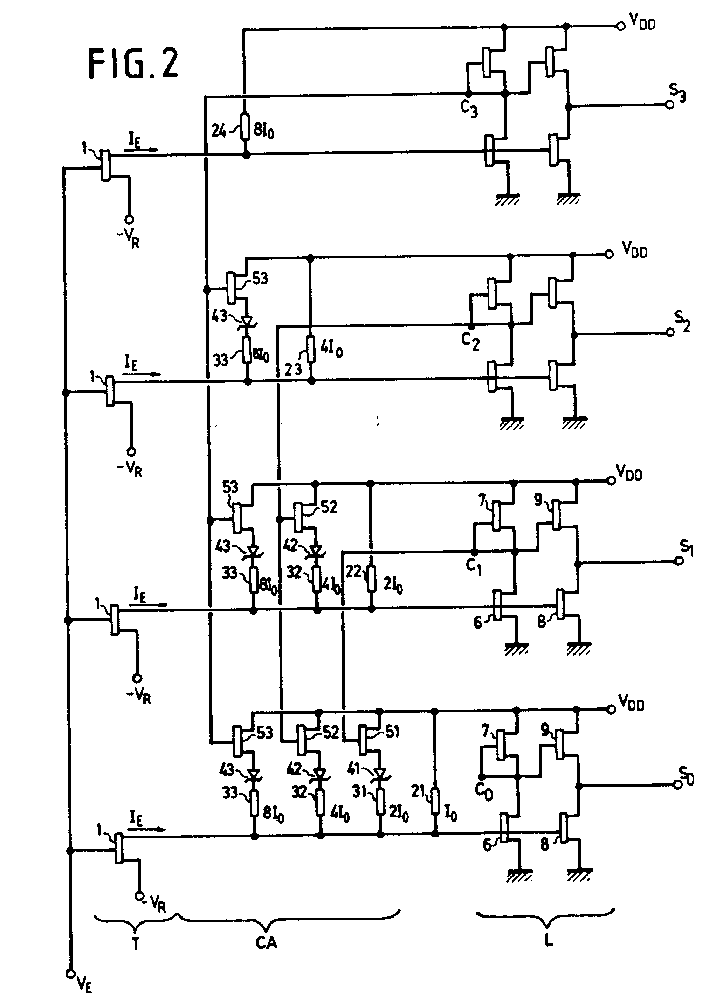

Ce schéma de la figure 1 sera détaillé en figure 2, mais auparavant un modèle logique permettra de facilement comprendre le principe du convertisseur selon l'invention.

Soit à déterminer, par approximations successives, un nombre décimal compris, par exemple, entre 0 et 63 ($2^6$ -1) en un nombre minimum d'opérations. On peut le comparer à $2^5$ puis, selon le résultat, le comparer à $2^5 + 2^4$, puis à $2^5 + 2^4 + 2^3$ et ainsi de suite. Il suffit de 6 niveaux de comparaisons pour déterminer un nombre compris entre 0 ($<2^0$) et 63 ($2^6 - 1$).

Dans le CAN selon l'invention, le niveau de bit de poids le plus élevé $2^n$ compare le courant $I_E$ à un courant étalonné $2^{n-1} I_o$, puis le niveau de bit de poids inférieur $2^{n-1}$ compare ce même courant $I_E$ à un courant étalonné $(2^{n-1} + 2^{n-2}) I_o$ et ainsi de suite. Le niveau de bit de poids le plus léger $2^0$ compare $I_E$ à un courant $(2^{n-1} + 2^{n-2} + ..... + 2^{n-n}) I_o$.

La figure 2 donne le schéma électrique du CAN selon l'invention. Elle reprend la configuration de la figure 1, et ne représente 4 bits que pour la rendre plus lisible, sans pour autant limiter la portée de l'invention.

Le signal analogique $V_E$ est adressé, en parallèle, à autant de transistors 1 qu'il y a de niveaux de bits dans le signal numérique de sortie. Chaque niveau de bit est constitué de trois étages : le transducteur, le comparateur, le circuit logique. Le premier étage transforme une tension $V_E$ en un courant $I_E$.

Dans le second étage, chaque comparateur analogique comprend une source de courant composite formée par :

– une source de courant constant 21 à 24, qui est soit une résistance, soit un transistor dont la grille est réunie à la source,

– une série de sources de courants élémentaires formées chacune par une résistance ou un transistor 31 à 33, une diode en série 41 à 43 et un transistor de commande 51 à 53.

Il a déjà été précisé que ces sources de courants élémentaires débitent des courants en progression géométrique $2^n I_o$ et que de plus toutes les sources élémentaires qui débitent un même courant $2^n I_o$ sont commandées, par l'intermédiaire de leur transistor 51 à 53, par la sortie $C_n$ du circuit logique du niveau de bit $S_n$.

Au niveau de bit de poids le plus élevé, le second étage ne comprend qu'une source de courant 24, non commandée.

Le courant total débité par une source de courant composite dépend des signaux de commande C qui lui sont adressés, par les circuits logiques L des niveaux de bits supérieurs : on y reviendra ultérieurement.

Le courant résultant du comparateur analogique CA est, à chaque niveau de bit, adressé au circuit logique L du troisième étage. Celui-ci est de type DCFL (Direct Coupled FET Logic) et comprend :

– un inverseur constitué par un transistor 6, normalement bloqué, et sa source de courant 7, normalement passant,

– un suiveur constitué par deux transistors 8 et 9, tous deux normalement bloqués, montés en série.

Le point commun au drain de 6 et à la source de 7 constitue une première sortie qui est adressée sur la grille de 9, et qui fournit le signal de commande C pour les comparateurs CA de niveaux inférieurs.

Le point commun au drain de 8 et à la source de 9, monté en source suiveusee, constitue une deuxième sortie qui fournit un bit du signal numérique.

Ce circuit logique est alimenté entre une tension $V_{DD}$ et la masse.

Le courant résultant $I_{CA} - I_E$ du comparateur analogique CA est appliqué en parallèle sur les deux grilles des transistors inverseurs 6 et 8.

Supposons que ce courant résultant soit à un niveau bas, c'est-à-dire que $I_E > I_{CA}$. Le transistor 6 est bloqué, parce qu'il est de type "normalement bloqué", mais le transistor 7 qui est de type passant tire vers le haut la tension du drain de 6 : la sortie de commande est à l'état haut : C est un 1 logique. De la même façon, le transistor 8 est bloqué, mais comme le signal appliqué sur la grille de 9 est haut, il débloque le transistor 9, et la sortie S est à l'état haut : S est un 1 logique.

Le raisonnement inverse s'applique si le courant résultant du comparateur analogique est à l'état haut, soit $I_E < I_{CA}$. Dans ce cas, les sorties C et S sont à l'état bas, ce sont des 0 logiques.

Les signaux de commande $C_o$ à $C_3$ issus des circuits logiques des quatre niveaux de bits commandent chacun une source de courant élémentaire dans tous les niveaux de bits de poids inférieurs : le signal $C_n$, correspondant à un bit de sortie de poids n, commande toutes les sources de courants élémentaires qui débitent un courant $2^n I_o$.

Ainsi, le courant de chaque source de courant étalonnée, dans chaque comparateur de niveau n est de la forme :

$$I_{CAn} = 2^n I_o + C_{n+1} 2^{n+1} I_o + \dots + C_{N-1} 2^{N-1} I_o$$

si N est le nombre total de niveaux de bits.

A titre d'exemple pris sur la figure 2 :

$$I_{CA3} = 2^3 I_o = 8\, I_o$$
$$I_{CA2} = 2^2 I_o + C_3 2^3 I_o = 4 I_o + C_3 8 I_o$$
$$I_{CA1} = 2 I_o + C_3 8 I_o + C_2 . 4 I_o$$
$$I_{CAo} = I_o + C_3 8 I_o + C_2 . 4 I_o + C_1 . 2 I_o$$

La CAN selon l'invention compare donc un courant $I_E$ au courant $I_{CA}$ fourni par des comparateurs en cascade, à partir du bit de poids le plus élevé. Chaque fois qu'on descend d'un niveau dans la cascade, on rétrécit l'intervalle de comparaison en ajoutant au courant du niveau supérieur un courant inférieur d'une puissance de 2 dans la progression géométrique.

Pour un CAN de 4 bits tel que représenté en figure 2, on peut mesurer 16 intervalles, ou 16 niveaux de tension d'entrée $V_E$. Le tableau suivant donne les états des sorties $S_o$ à $S_3$ en fonction des états des signaux de commandes $C_o$ à $C_3$, et les courants des comparateurs $I_{CA0}$ à $I_{CA3}$, pour les 16 niveaux de $V_E$ ou de $I_E$.

## TABLEAU I

| $V_E$ / $I_E$ | $I_{CA3}$ / $I_o$ | $C_3$ / $S_3$ | $I_{CA2}$ / $I_o$ | $C_2$ / $S_2$ | $I_{CA1}$ / $I_o$ | $C_1$ / $S_1$ | $I_{CAo}$ / $I_o$ | $C_o$ / $S_o$ |
|---|---|---|---|---|---|---|---|---|
| 16 | 8 | 1 | 12 | 1 | 14 | 1 | 15 | 1 |
| 15 | 8 | 1 | 12 | 1 | 14 | 1 | 15 | 0 |
| 14 | 8 | 1 | 12 | 1 | 14 | 0 | 13 | 1 |
| 13 | 8 | 1 | 12 | 1 | 14 | 0 | 13 | 0 |
| 12 | 8 | 1 | 12 | 0 | 10 | 1 | 11 | 1 |
| 11 | 8 | 1 | 12 | 0 | 10 | 1 | 11 | 0 |
| 10 | 8 | 1 | 12 | 0 | 10 | 0 | 9 | 1 |
| 9 | 8 | 1 | 12 | 0 | 10 | 0 | 9 | 0 |
| 8 | 8 | 0 | 4 | 1 | 6 | 1 | 7 | 1 |
| 7 | 8 | 0 | 4 | 1 | 6 | 1 | 7 | 0 |
| 6 | 8 | 0 | 4 | 1 | 6 | 0 | 5 | 1 |
| 5 | 8 | 0 | 4 | 1 | 6 | 0 | 5 | 0 |
| 4 | 8 | 0 | 4 | 0 | 2 | 1 | 3 | 1 |
| 3 | 8 | 0 | 4 | 0 | 2 | 1 | 3 | 0 |
| 2 | 8 | 0 | 4 | 0 | 2 | 0 | 1 | 1 |
| 1 | 8 | 0 | 4 | 0 | 2 | 0 | 1 | 0 |

La réalisation de ce CAN ne comporte que des transistors et des diodes. Sont de type normalement passant :

– les transducteurs 1 tension-courant (tension de seuil $V_T$ = -1 V)

– les sources de courants étalonnées 21 à 24 et 31 à 33 ($V_T$ = - 0,5V)

– les charges actives 7 dans les inverseurs ($V_T$ = - 05,V).

Les autres transistors sont de type normalement bloqué ($V_T$ = 0,1 V)

La tension négative de rappel - $V_R$, appliquée sur les sources des transducteurs 1, permet de ramener le niveau bas du drain de ces transducteurs à environ + 0,1 volt, pour être compatible avec le circuit logique L constitué par les transistors 6 à 9.

Le niveau bas des signaux de commande C est de l'ordre de + 0,2 volt. Pour bloquer complètement les transistors de commande 51 à 53, qui ont une tension de seuil de + 0,1 volt, une diode 41 à 43 est incorporée entre la source des transistors 51 à 53 et les sources de courants étalonnés 31 à 33, ce qui remonte la tension de seuil des transistors 51 à 53 à environ + 0,3 volt.

Le CAN représenté en figure 2 peut mesurer des tensions comprises entre - 1 volt et - 0,2 volt en 16 intervalles de 50 mV.

Si la tension d'entrée $V_E$ doit être convertie avec une plus grande précision, par exemple 8 bits, il faut 256 intervalles, et si l'on sait faire des transistors dont la sensibilité est 10 mV, il faut une tension de seuil pour le transducteur 1 de l'ordre de - 2,5 volts.

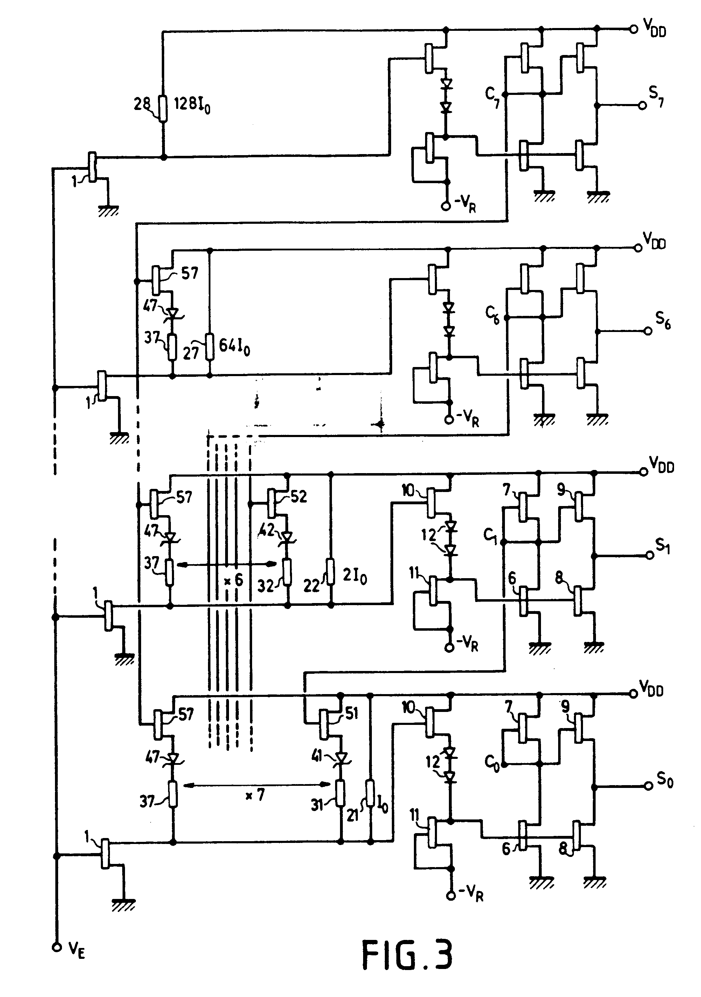

Il est alors préférable d'intercaler entre le comparateur CA et le circuit logique L un étage décaleur-suiveur, tel que représenté en figure 3.

La figure 3 donne le schéma électrique en 8 bits de sortie d'une variante du CAN selon l'invention. Mais pour rendre cette figure plus claire, seuls ont été représentés les deux premiers et les deux derniers niveaux de bits (bits $S_0$ et $S_1$, $S_6$ et $S_7$). En outre, les comparateurs des niveaux 0 et 1 ont été simplifiés : $CA_o$ comprend 7 sources de courants élémentaires 31 à 37, et $CA_1$ en comprend 6.

Les indices de repères sont les mêmes qu'en figure 2.

Outre le nombre de bits, la figure 3 diffère de la figure 2 en deux points, pour chaque niveau :

– la source des transducteurs 1 tension-courant est à la masse, au lieu d'être réunie à - $V_R$.

– un étage décaleur-suiveur, alimenté entre $V_{DD}$ et - $V_R$, est intercalé en sortie du comparateur CA.

Cet étage est composé d'un transistor 10, ayant même tension de seuil (-2,5 volts) que le transducteur 1, et monté en source suiveuse au moyen d'une source de courant 11, qui tire la tension vers - $V_R$, et d'une ou plusieurs diodes 12 pour ramener la tension de sortie à un niveau compatible avec le transistor 6 du circuit logique. Le signal de sortie du comparateur analogique est appliqué sur la grille du transistor 10, et le signal de sortie du décaleur, prélevé sur le drain du transistor 11 est appliqué sur la grille du transistor 6.

Le calcul du nombre de composants nécessaires pour réaliser ce CAN 8 bits donnera une idée de l'intérêt de cette structure. Pour 8 bits, il faut :

- transducteurs 1               = 8 transistors

- décaleurs 10 + 11        = 16 transistors

- circuits logiques 6+7+8+9     = 32 transistors

– sources de courants élémentaires 21 à 28 et 31 à 37 : 1 transistor pour le bit le plus lourd, et un transistor de plus chaque fois qu'on descend d'un niveau de bit, soit 36 transistors,

– transistors de commande 51 à 57 : 36 transistors soit au total 128 transistors, auxquels il faut ajouter 52 diodes 12 et 41 à 47 : le CAN selon l'invention comporte en tout 180 composants semiconducteurs.

A titre de comparaison, un CAN classique à 8 bits, nécessite 256 comparateurs linéaires, dont le seul encodeur de transformation de l'échelle analogique en nombre binaire exige déjà 1540 transistors.

Les seuls éléments de précision dans le CAN à cascade selon l'invention sont les 36 sources de courants élémentaires 21 à 28 et 31 à 37 (pour 8 bits) et les 8 transducteurs 1 dont la tension de seuil doit être contrôlée à quelques millivolts près.

Sur les figures, les sources de courants élémentaires ont été représentées par le symbole d'une résistance, pour simplifier les figures. En fait, il est préférable de les réaliser au moyen de transistors dont la grille est réunie à la source : la largeur de canal contrôle l'intensité débitée, et ceci a l'avantage d'unifier la technologie de réalisation exclusivement à base de semiconducteurs.

Le CAN à cascade selon l'invention est utilisé dans le traitement de l'information. Il est préférentiellement réalisé en circuit intégré, sur silicium ou sur matériaux III-V tel que GaAs pour travailler dans les hyperfréquences : en effet, entre le signal d'entrée $V_E$ et le signal de sortie $S_0 S_1 S_2...$, il n'y a que deux jonctions de grilles des transistors 1 et 8, et trois jonctions s'il y a un étage déceleur 10, ce qui lui confère une très grande rapidité.

**Revendications**

1. Convertisseur analogique-numérique, transformant un signal analogique d'entrée ($V_E$) en un signal numérique de sortie formé par une pluralité de bits (S), ce convertisseur étant du type à cascade dans lequel le signal d'entrée ($V_E$), converti en un courant ($I_E$) par un transducteur (T), est adressé en parallèle à une même pluralité de circuits de niveaux de bits dans lesquels il est comparé dans un comparateur (CA) à un courant étalonné ($I_{CA}$) fourni par un ensemble de sources de courant élémentaires (31-33) connectées en parallèle dont les courants débités vont en progression géométrique, les dites sources étant, chacune, commandées par un étage de sortie (L) de bit d'ordre supérieur, ce convertisseur étant caractérisé en ce que, pour chaque niveau de bit, l'étage de sortie (L) est un circuit logique qui comprend :
   − un inverseur constitué par un premier transistor inverseur (6) normalement bloqué, et un transistor (7) source de courant, normalement passant,
   − un suiveur constitué par un second transistor inverseur (8) en série avec un transistor (9) monté en source suiveuse, tous deux normalement bloqués, la grille du transistor (9) monté en source suiveuse étant réunie au point commun (C) aux deux transistors (6,7) de l'inverseur,
   − le signal issu du comparateur (CA) état appliqué sur les grilles des deux transistors inverseurs (6,8),
   − le point commun (C) aux deux transistors (6,7) de l'inverseur constituant une première sortie de commande des sources de courants élémentaires (31-33) du comparateur, et le point commun (S) aux deux transistors (8,9) du suiveur constituant une seconde sortie du bit.

2. Convertisseur analogique-numérique selon la revendication 1, caractérisé en ce que, pour chaque niveau de bit, il y a dans le comparateur analogique (CA) autant de sources de courants élémentaires (31 à 33) commandées par un transistor (51 à 53) qu'il y a de niveaux de bits de poids supérieurs dans le convertisseur.

3. Convertisseur analogique-numérique selon la revendication 1, caractérisé en ce que les premières sorties (C) des circuits logiques (L), considérées dans l'ordre croissant de poids des bits, commandent chacune l'une des sources de courants élémentaires commandées (31 à 33) de chacun des niveaux de poids inférieurs, dans l'ordre croissant de la progression géométrique.

4. Convertisseur analogique-numérique selon la revendication 2, caractérisé en ce que les transistors de commande (51 à 53) des sources de courants commandées (31 à 33) étant de type normalement bloqué, à tension de seuil positive, une diode (41 à 43) de décalage de tension est introduite entre chaque transistor et la source de courant qu'il commande, afin de bloquer ce transistor, dans le cas où le niveau bas du signal de commande (C) est légèrement positif.

5. Convertisseur analogique-numérique selon la revendication 1, caractérisé en ce que, en vue d'obtenir un grand nombre de bits pour le signal numérique de sortie, et d'augmenter la précision de chaque niveau de bit, un étage décaleur de tension (10+11+12) est introduit entre l'étage comparateur analogique (CA) et l'étage du circuit logique (L) pour chaque niveau de bit.


**Claims**

1. An analog-digital converter for transforming an analog input signal ($V_E$) into a digital output signal constituted by a plurality of bits (S), said converter being of the cascade type in which the input signal ($V_E$), converted into a current ($I_E$) by a transducer (T), is addressed in parallel to an identical plurality of bit level circuits in which it is compared in a comparator (CA) with a gaged current ($I_{CA}$) provided by a group of elementary current sources (31 through 33) connected in parallel, whose supplied currents are in a geometrical progression, each of said sources being controlled by a higher order bit output stage (L), said converter being characterized in that for each bit level the output stage (L) is a logic circuit which comprises:
   − an inverter constituted by a first inverting, normally turned off transistor (6) and a normally turned on current source transistor (7),
   − a follower constituted by a second inverting transistor (8) in series with a transistor (9) connected as a source follower, the two being normally turned off, the gate of the transistor (9) connected as the source follower being connected with the common point (C) of the two transistors (6, 7) of the inverter,
   − the signal from the comparator (CA) being applied to the gates of the two inverting transistors (6, 8),
   − the common point (C) of the two transistors (6, 7) of the inverter constituting a first output for the control of the elementary current sources (31 through 33) of the comparator and the common point (S) of the two transistors (8, 9) of the follower constituting a second output for the bit.

2. The analog-digital converter as claimed in claim 1, characterized in that for each bit level the analog comparator (CA) comprises as many elementary current sources (31 through 33) controlled by a transistor (51 through 53) as there are bit levels of higher significance in the converter.

3. The analog-digital converter as claimed in claim 1 , characterized in that the first outputs (C) of the logic circuits (L), considered in the increasing order of bit significance, each control one of the controlled elementary current sources (31 through 33) of each of the less significant levels, in increasing order of geometrical progression.

4. The analog-digital converter as claimed in claim 2, characterized in that the control transistors (51 through 53) of the controlled sources of current (31 through 33) being of the normally turned off type, with a positive threshold voltage, a diode (41 through 43) for voltage offset is arranged between each transistor and the current source which it controls in order to turn off this transistor if the low level of the control signal (C) is slightly positive.

5. The analog-digital converter as claimed in claim 1 , characterized in that for the purpose of producing a large number of bits for the digital output signal and for increasing the precision of each bit level, a voltage offset stage (10 + 11 + 12) is arranged between the analog comparison stage (CA) and the logic circuit stage (L) for each bit level.


## Patentansprüche

1. Analog/Digital-Umsetzer, der ein analoges Eingangssignal ($V_E$) in ein aus einer Anzahl von Bits (S) gebildetes digitales Ausgangssignal umformt, wobei dieser Umsetzer vom Kaskadentyp ist, in dem das mittels eines Wandlers (T) in einen Strom ($I_E$) umgewandelte Eingangssignal ($V_E$) parallel an die gleiche Anzahl von Bitpegel-Schaltungen angelegt wird, in denen es in einem Komparator (CA) mit einem geeichten Strom ($I_{CA}$) verglichen wird, der von einer Gruppe von parallel geschalteten Elementarstromquellen (31 - 33) geliefert wird, deren Ströme in geometrischer Abstufung abgegeben werden, wobei die genannten Quellen jeweils von einer Ausgangsstufe (L) eines Bits höherer Ordnung gesteuert werden, wobei dieser Umsetzer dadurch gekennzeichnet ist, daß die Ausgangsstufe (L) für jeden Bitpegel eine Logikschaltung ist, die umfaßt:
  – einen Inverter, der von einem normalerweise gesperrten ersten Inverter-Transistor (6) und von einem normalerweise durchlassenden Stromquellen-Transistor (7) gebildet ist,
  – einen Folger, der von einem zweiten Inverter-Transistor (8) und von einem hierzu in Reihe geschalteten Transistor (9), der als Source-Folger geschaltet ist, gebildet ist, wobei diese beiden Transistoren normalerweise gesperrt sind und das Gate des als Source-Folger geschalteten Transistors (9) an einem gemeinsamen Punkt (C) mit den beiden Transistoren (6, 7) des Inverters verbunden ist,
  – wobei das vom Komparator (CA) ausgegebene Signal an die Gates der zwei Inverter-Transistoren (6, 8) angelegt wird, und
  – der gemeinsame Punkt (C) der zwei Transistoren (6, 7) des Inverters einen ersten Ausgang für die Steuerung der Elementarstromquellen (31 - 33) des Komparators bildet und der gemeinsame Punkt (S) der zwei Transistoren (8, 9) des Folgers einen zweiten Ausgang für das Bit bildet.

2. Analog/Digital-Umsetzer gemäß Anspruch 1, dadurch gekennzeichnet, daß für jeden Bitpegel im analogen Komparator (CA) soviele von einem Transistor (51 - 53) gesteuerte Elementarstromquellen (31 - 33) vorgesehen sind wie im Umsetzer Bitpegel mit höherer Wertigkeit vorhanden sind.

3. Analog/Digital-Umsetzer gemäß Anspruch 1, dadurch gekennzeichnet, daß die ersten Ausgänge (C) der Logikschaltungen (L), betrachtet in der Reihenfolge wachsender Bitwertigkeit, jeweils eine der gesteuerten Elementarstromquellen (31 - 33) eines jeden Pegels mit niedrigerer Wertigkeit in der Reihenfolge zunehmender geometrischer Abstufung steuern.

4. Analog/Digital-Umsetzer gemäß Anspruch 2, dadurch gekennzeichnet, daß in dem Fall, daß die Transistoren (51 - 53) für die Steuerung der gesteuerten Stromquellen (31 - 33) vom normalerweise gesperrten Typ mit positiver Schwellenspannung sind, zwischen jeden Transistor und die von ihm gesteuerte Stromquelle eine Spannungsverschiebungsdiode (41 - 43) geschaltet ist, um diesen Transistor zu sperren, falls der niedrige Pegel des Steuersignals (C) geringfügig positiv ist.

5. Analog/Digital-Umsetzer gemäß Anspruch 1, dadurch gekennzeichnet, daß für die Gewinnung einer großen Anzahl von Bits für das digitale Ausgangssignal und für die Erhöhung der Genauigkeit eines jeden Bitpegels zwischen die Stufe des analogen Komparators (CA) und die Stufe der Logikschaltung (L) für jeden Bitpegel eine Spannungsverschiebungsstufe (10 + 11 + 12) geschaltet ist.

# FIG.1

# FIG.2

FIG.3